# EUROPÄISCHE PATENTSCHRIFT

(11) **EP 1 249 035 B1**
(45) Veröffentlichungstag und Bekanntmachung des Hinweises auf die Patenterteilung: **09.08.2006**
(21) Anmeldenummer: 01905609.2
(22) Anmeldetag: 08.01.2001
(51) Int. Cl.: H01L 29/737

(54) **SILIZIUM-GERMANIUM-BIPOLARTRANSISTOR MIT OPTIMIERTEM GERMANIUMPROFIL**
SILICON/GERMANIUM BIPOLAR TRANSISTOR WITH AN OPTIMIZED GERMANIUM PROFILE
TRANSISTOR BIPOLAIRE AU SILICIUM-GERMANIUM AVEC PROFIL DE GERMANIUM OPTMISE

(30) Priorität: 20.01.2000 DE 10002364
(43) Veröffentlichungstag der Anmeldung: 16.10.2002
(73) Patentinhaber: Infineon Technologies AG, 81669 München (DE)
(72) Erfinder: KLEIN, Wolfgang, 85604 Zorneding (DE); LACHNER, Rudolf, 85051 Ingolstadt (DE); MOLZER, Wolfgang, 85521 Ottobrunn (DE)
(74) Vertreter: Epping - Hermann - Fischer
(86) Internationale Anmeldenummer: PCT/DE2001/000033
(87) Internationale Veröffentlichungsnummer: WO 2001/054167

(56) Entgegenhaltungen:
- EP-A- 0 541 971
- EP-A- 0 818 829
- DAS K ET AL: "COPPER-BASED OHMIC CONTACTS FOR THE SIGE/SI HETEROJUNCTION BIPOLAR TRANSISTOR (HBT) STRUCTURE" SAN FRANCISCO, CA, APRIL 5 - 7, 1999,WARRENDALE, PA: MRS,US, Bd. 564, 5. April 1999 (1999-04-05), Seiten 195-200, XP000873803 ISBN: 1-55899-471-8
- ROBBINS D J: "CHARACTERISATION OF HETEROJUNCTION BIPOLAR TRANSISTORS INCORPORATING SI/SI1-XGEX EPITAXIAL DOUBLE LAYERS WITH N+ EMITTER IMPLANTS" PROCEEDINGS OF THE EUROPEAN SOLID STATE DEVICE RESEARCH CONFERENCE. (ESSDERC),NL,AMSTERDAM, ELSEVIER, Bd. CONF. 22, 14. September 1992 (1992-09-14), Seiten 447-450, XP000357120
- NGUYEN-NGOC D ET AL: "ION-IMPLANTED BASE SIGE PNP SELF-ALIGNED SEEW TRANSISTORS" PROCEEDINGS OF THE BIPOLAR CIRCUITS AND TECHNOLOGY MEETING,US,NEW YORK, IEEE, Bd. -, 9. September 1991 (1991-09-09), Seiten 75-78, XP000245955

## Beschreibung

Die Erfindung betrifft einen Silizium-Germanium-Bipolartransistor, dessen Germaniumkonzentrationsprofil zur Reduzierung der arbeitspunktabhängigen Variation der Stromverstärkung optimiert ist.

Silizium-Germanium-Bipolartransistoren, kurz SiGeBTs, stellen eine Weiterentwicklung der Silizium-Bipolartransistoren dar und zeichnen sich durch besondere Leistungsfähigkeit im Hochfrequenzbereich aus.
Bei diesen SiGeBTs sind der Basisbereich und die Randzone des angrenzenden Emitterbereichs gezielt mit Germanium (Ge) legiert. Bei Verwendung eines geeigneten Ge-Konzentrationsprofils ist in diesem Bereich des Transistors der Bandabstand zwischen Valenz- und Leitungsband geringer mit der Wirkung, daß Ladungsträger den Basisbereich schneller durchlaufen. Daher besitzen SiGeBTs sehr hohe Grenzfrequenzen und eignen sich besonders für Hochfrequenzanwendungen. Solche SiGeBTs sind zum Beispiel bekannt aus F. Crabbe et al, IEEE Electron Device Letters, Vol. 4, 1993.
SiGe BTs sind auch aus EP-A-O 818 829 bekannt.
Üblicherweise ist bei einem SiGeBT der Basisbereich mit 10 bis 25 Gewichtsprozent Ge legiert. Der Übergang der Ge-Konzentration von Emitter zur Basis verläuft entweder abrupt oder näherungsweise linear ansteigend. Hinsichtlich der Hochfrequenzeigenschaften von SiGeBTs hat sich ein Ge-Konzentrationsprofil mit näherungsweise linearem Anstieg als optimal herausgestellt.

Dieses Konzentrationsprofil besitzt den Nachteil, daß die Stromverstärkung stark von dem jeweils fließenden Kollektorstrom abhängt. Dieser Nachteil ist darauf zurückzuführen, daß die Stromverstärkung eines Transistors mit der Lage der Raumladungszone des Emitter/Basis-pn-Übergangs, kurz EB-Raumladungszone, zusammenhängt. Hierbei sind folgende zwei Faktoren wesentlich:
Zum einen sinkt die Stromverstärkung eines Transistors mit steigender Basisladung, die durch die Lage der Raumladungszone bestimmt ist.
Zum anderen hängt die Stromverstärkung negativ exponentiell vom Bandabstand in der Basis - insbesondere an der basisseitigen Grenze der EB-Raumladungszone - ab.
Mit steigender Basis-Emitter-Spannung wandert die basisseitige Grenze der EB-Raumladungszone in Richtung Emitter, so daß einerseits die Basisladung steigt und sich andererseits an dieser Grenze der Bandabstand aufgrund der sinkenden Ge-Konzentration vergrößert. Beide Effekte führen zu einer starken Reduktion der Stromverstärkung.
Da mit steigender Basis-Emitter-Spannung auch der Kollektorstrom steigt, hängt mittelbar die Stromverstärkung vom Kollektorstrom bzw. vom Arbeitspunkt des Transistors ab und sinkt stark mit steigendem Kollektorstrom. Diese Abhängigkeit ist unerwünscht, da dadurch die Linearität des Transistors verschlechtert bzw. der Dynamikbereich des Transistors eingeschränkt wird.

Aufgabe der vorliegenden Erfindung ist es, diese arbeitspunktabhängige Variation der Stromverstärkung eines SiGeBTs zu verringern.

Diese Aufgabe wird erfindungsgemäß durch einen Silizium-Germanium-Transistor nach Anspruch 1 gelöst.

Bei dem erfindungsgemäßen Transistor weicht in einem engen Bereich in der Umgebung des EB-Raumladungszone das Ge-Konzentrationsprofil von den üblichen Ge-Profilen mit näherungsweise linearem Anstieg der Ge-Konzentration ab. Erfindungsgemäß ist die Ge-Legierung so ausgeführt, daß sich bei einer Verschiebung der basisseitigen Grenze der EB-Raumladungszone die Faktoren, die die Änderung der Stromverstärkung verursachen, weitgehend kompensieren.
Die Variation der Stromverstärkung wird um so geringer, je geringer der Anstieg der Ge-Konzentration in Richtung Kollektor ist und je weiter dieser Anstieg in Richtung Kollektor verschoben ist. Bei den erfindungsgemäßen Ge-Dotierungsprofilen steigt die Ge-Konzentration zur Basis hin in der Umgebung der EB-Raumladungszone gegenüber den angrenzenden Bereichen weniger stark an oder fällt ab.
Vorteilhafte Weiterbildungen der Erfindung sind in den untergeordneten Ansprüchen angegeben.

In einer vorteilhaften Ausgestaltung der Erfindung wird in der Umgebung der EB-Raumladungszone die Ge-Konzentration auf einem geeigneten Niveau konstant gehalten.

In einer weiteren, bevorzugten Ausgestaltung der Erfindung ist das Ge-Profil so gestaltet, daß die Ge-Konzentration in der Umgebung des EB-Raumladungszone abnimmt. Dabei ist das Gefälle der Konzentration so gewählt, daß die arbeitspunktabhängige Variation der Stromverstärkung optimal kompensiert ist.

In vorteilhafter Weise wird bei dieser Erfindung die fertigungsbedingte Exemplarstreuung bei SiGeBTs hinsichtlich der Nominalstromverstärkung vermindert.
Diese meist sehr große Schwankung der Nominalstromverstärkung von SiGeBTs beruht darauf, daß aufgrund von unvermeidbaren Fertigungstoleranzen die genaue Lage des Emitter-Basis-pn-Übergangs relativ zum Ge-Profil von Transistor zu Transistor variiert. Bei erfindungsgemäßer Gestaltung des Germaniumprofils führt diese fertigungtechnisch bedingte Variation zu geringeren Änderungen der Nominalstromverstärkung als bei SiGeBTs nach dem Stand der Technik.

Ein weiterer Vorzug dieser Erfindung besteht darin, daß aufgrund der gezielten Veränderung der Ge-Konzentration im Bereich des Emitter-Basis-pn-Übergangs bzw. der Anpassung der Ge-Konzentration in diesem Bereich an den maximalen Ge-Gehalt die Nominalstromverstärkung sehr genau einstellbar ist.

Da nur ein kleiner Bereich im linearen Anstieg des Ge-Profils modifiziert wird, werden die Hochfrequenzeigenschaften eines SiGeBT durch die erfindungsgemäße Gestaltung des Ge-Profils nur marginal verändert.

Nachfolgend wird die Erfindung anhand zweier Ausführungsbeispiele unter Bezugnahme auf die Zeichnung näher erläutert.

### Es zeigen:

Fig. 1 den schematischen Aufbau eines SiGeBT mit optimiertem Ge-Profil,
Fig. 2 zwei erfindungsgemäße Ge-Profile im Vergleich zu einem Ge-Profil nach dem Stand der Technik und
Fig. 3 schematisch die berechnete Stromverstärkung in Abhängigkeit der Kollektorstromdichte für die in Fig. 2 dargestellten Ge-Profile.

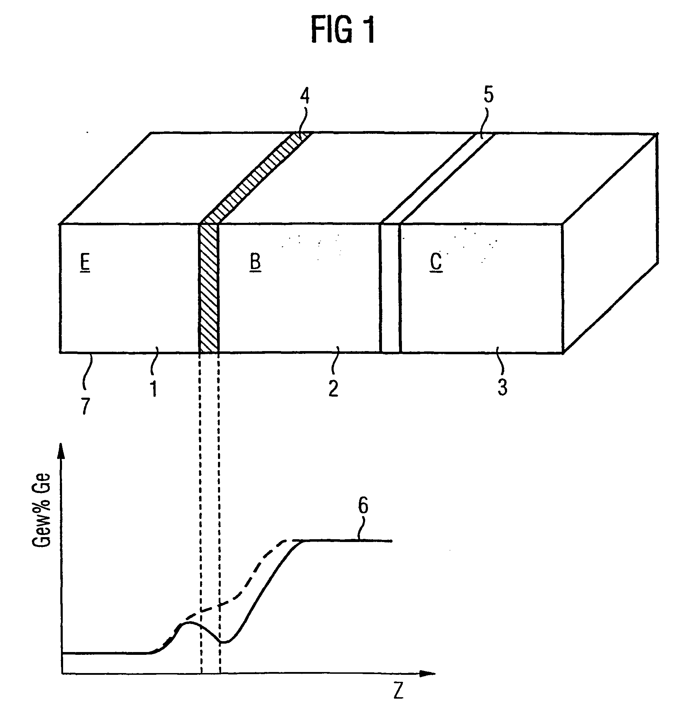

In Fig. 1 ist perspektivisch der Halbleiterkörper eines SiGeBT dargestellt und in der Zeichenebene das erfindungsgemäße Ge-Profil aufgetragen.
In einem Siliziumsubstrat 7 ist ein n-dotierter Emitterbereich 1 ausgebildet, an den sich ein p-dotierter Basisbereich 2 anschließt, gefolgt wiederum von einem n-dotierten Kollektorbereich 3. Zwischen dem Emitterbereich 1 und dem Basisbereich 2 befindet sich die EB-Raumladungszone 4, zwischen Basisbereich 2 und dem Kollektorbereich 3 die Basis-Kollektor-Raumladungszone 5.
Im Basisbereich 2 und im anschließenden Randbereich des Emitters 1 ist der Transistor mit Ge legiert. Das Ge-Konzentrationsprofil 6 ist längs des Transistors graphisch für zwei erfindungsgemäß Ausführungen dargestellt.
Die Ge-Konzentration 6 steigt im Emitterbereich zur Basis hin zunächst an. Erfindungsgemäß weicht das Konzentrationsprofil 6 im Übergangsbereich zwischen Basis und Emitter, in dem die EB-Raumladungszone 4 liegt, von einer linearen Abhängigkeit ab. Vorzugsweise nimmt in diesem Übergangsbereich die Ge-Konzentration in Richtung Basis 2 ab.

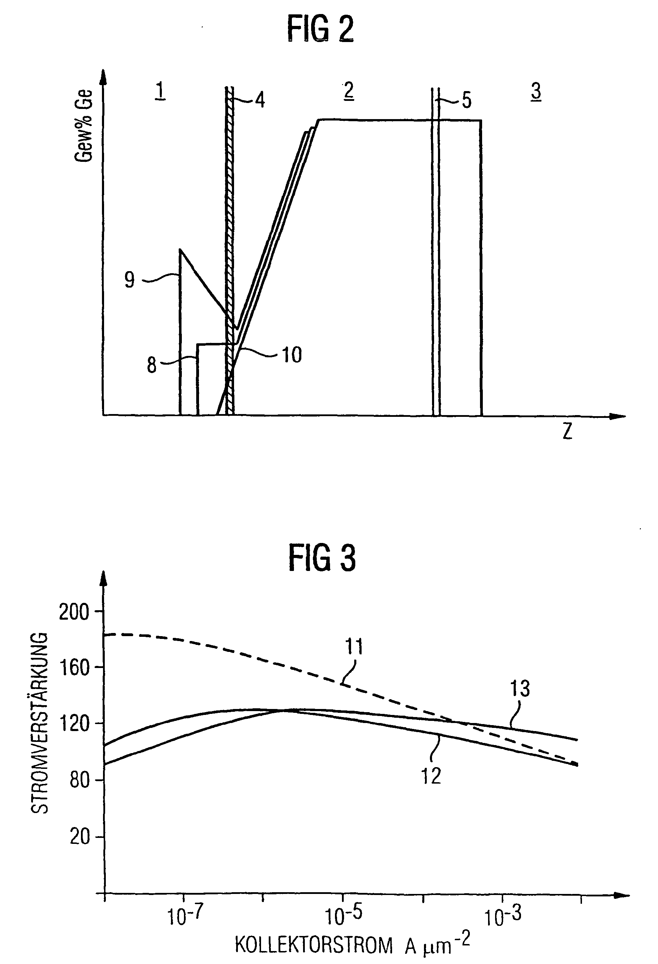

Fig. 2 zeigt drei Ge-Profile, für die die Stromverstärkung in Abhängigkeit des Kollektorstroms berechnet wurde. Profil 10 zeigt den Stand der Technik mit linearem Verlauf des Ge-Profils zwischen Emitter 1 und Basis 2. Bei dem erfindungsgemäßen Profil 8 weist der Ge-Konzentrationsverlauf in der Umgebung der EB-Raumladungszone 4 ein Plateau auf. Die Ge-Konzentration ist diesem Bereich konstant. Das erfindungsgemäße Profil 9 stellt ein sogenanntes "negative graded profile" dar, bei dem die Ge-Konzentration in der Umgebung der EB-Raumladungszone 4 zur Basis hin abnimmt. Die Plateauhöhe bei Profil 8 bzw. das Konzentrationsminimum im Emitter-BasisBereich bei Profil 9 ist dabei an den weiteren Ge-Konzentrationsverlauf in der Basis 2 und den maximalen Ge-Gehalt im Kollektor 3 angepaßt.

In Fig. 3 ist die aus Simulationsrechnungen gewonnene Stromverstärkung in Abhängigkeit des Kollektorstroms für die in Fig. 2 gezeigten Ge-Profile dargestellt.

Die zum Ge-Profil 10 gehörende, den Stand der Technik beschreibende Stromverstärkungskurve 11 variiert in dem dargestellten Intervall um über 50%, bezogen auf den Maximalwert der Stromverstärkung. Demgegenüber weist die Stromverstärkungskurve 12 des erfindungsgemäßen Ge-Profils 8 bzw. Kurve 13 für Profil 9 generell einen sehr viel geringeren Variationsbereich auf. Hier variiert die Stromverstärkung in dem dargestellten Bereich um weniger als 30%, bezogen auf den Maximalwert der Stromverstärkung.

In ihrer Wirkung unterscheiden sich die erfindungsgemäßen Ge-Profile 8 und 9 vor allem im Abfall der Stromverstärkung in Abhängigkeit der Kollektorstromdichte jenseits der maximalen Stromverstärkung. Hier erweist sich Profil 9 als besonders vorteilhaft, da die zugehörige Stromverstärkungskurve 13 das geringste Gefälle aufweist, also am wenigsten durch einen veränderlichen Kollektorstrom beeinflußt wird.

Wie bereits ausgeführt beruht die vorteilhafte, geringere Variation der Stromverstärkung auf dem Verlauf des Bandabstands in der Umgebung der EB-Raumladungszone. Bei den erfindungsgemäßen Transistoren wird dieser Verlauf mittels eines geeigneten Ge-Konzentrationsprofils erreicht.
Die geringere Variation der Stromverstärkung kann auch durch andere Mittel, die den Bandabstand in gleicher Weise modifizieren, realisiert werden. Beispielsweise sind dies anderweitige Dotierungen oder Verspannungen des Halbleitersubstrats.

## Patentansprüche

1. Silizium-Germanium-Bipolartransistor,
bei dem in einem Siliziumsubstrat (7) ein erster n-dotierten Emitterbereich (1) und
daran anschließend ein zweiter p-dotierter Basisbereich (2) und
daran anschließend ein dritter n-dotierter Kollektorbereich (3) ausgebildet ist,
und zwischen Emitterbereich (1) und Basisbereich (2) eine erste Raumladungszone (4)
und zwischen Basisbereich (2) und Kollektorbereich (3) eine zweite Raumladungszone (5) ausgebildet ist,
wobei der Basisbereich (2) und die Randzone des angrenzenden Emitterbereichs (1) mit Germanium legiert ist,
und die Germaniumkonzentration (6) im Emitterbereich (1) zum Basisbereich (2) hin ansteigt,
die Germaniumkonzentration in einem Übergangsbereich, in dem die erste Raumladungszone (4) liegt, weniger stark ansteigt als im Emitterbereich (1) oder abnimmt
und die Germaniumkonzentration (6) im Basisbereich (2) zunächst stärker ansteigt als im Übergangsbereich.

2. Silizium-Germanium-Bipolartransistor nach Anspruch 1, wobei die Germaniumkonzentration (6) in dem Übergangsbereich, in dem die erste Raumladungszone (4) liegt, konstant ist.

3. Silizium-Germanium-Bipolartransistor nach Anspruch 1, wobei die Germaniumkonzentration (6) in dem Übergangsbereich, in dem die erste Raumladungszone (4) liegt, linear abfällt.

4. Silizium-Germanium-Bipolartransistor nach Anspruch 1 bis 3, wobei der Emitterbereich (1) und der Kollektorbereich (3) p-dotiert sind und der Basisbereich (2) n-dotiert ist.

## Claims

1. Silicon-germanium bipolar transistor,
in which, in a silicon substrate (7), there are formed a first n-doped emitter region (1) and, adjoining the latter, a second p-doped base region (2) and, adjoining the latter, a third n-doped collector region (3),
and a first space charge zone (4) is formed between emitter region (1) and base region (2) and a second space charge zone (5) is formed between base region (2) and collector region (3),
wherein the base region (2) and the edge zone of the adjoining emitter region (1) is alloyed with germanium,
and, in the emitter region (1), the germanium concentration (6) rises towards the base region (2),
in a junction region in which the first space charge zone (4) is located, the germanium concentration rises less sharply than in the emitter region (1) or decreases,
and, in the base region (2), the germanium concentration (6) initially rises more sharply than in the junction region.

2. Silicon-germanium bipolar transistor according to Claim 1,
wherein the germanium concentration (6) is constant in the junction region in which the first space charge zone (4) is located.

3. Silicon-germanium bipolar transistor according to Claim 1,
wherein the germanium concentration (6) falls linearly in the junction region in which the first space charge zone (4) is located.

4. Silicon-germanium bipolar transistor according to Claims 1 to 3, wherein the emitter region (1) and the collector region (3) are p-doped and the base region (2) is n-doped.

## Revendications

1. Transistor bipolaire au silicium-germanium,
dans lequel il est formé dans un substrat (7) en silicium une première zone (1) d'émetteur à dopage du type n, et
ensuite une deuxième zone (2) de base à dopage du type p, et
ensuite une troisième zone (3) de collecteur à dopage du type n,
et il et formé entre la zone (1) d'émetteur et la zone (2) de base une première zone (4) de charge d'espace
et entre la zone (2) de base et la zone (3) de collecteur, une deuxième zone (5) de charge d'espace,
dans lequel la zone (2) de base et la région marginale de la zone (1) d'émetteur voisine sont alliées à du germanium,
et la concentration (6) de germanium dans la zone (1) d'émetteur augmente en direction de la zone (2) de base,
la concentration de germanium dans une zone de transition, dans laquelle se trouve la première région (4) de charge d'espace, augmentant moins intensément que dans la zone (1) d'émetteur ou diminuant
et la concentration (6) de germanium dans la zone (2) de base augmentant d'abord plus fortement que dans la zone de transition.

2. Transistor bipolaire au silicium-germanium, suivant la revendication 1,
dans lequel la concentration (6) de germanium dans la zone de transition, dans laquelle se trouve la première région (4) de charge d'espace, est constante.

3. Transistor bipolaire au silicium-germanium,suivant la revendication 1, dans lequel la concentration (6) de germanium dans la zone de transition, dans laquelle se trouve la première région (4) de charge d'espace, décroît linéairement.

4. Transistor bipolaire au silicium-germanium, suivant la revendication 1 à 3, dans lequel la zone (1) d'émetteür et la zone (3) de collecteur sont à dopage du type p et la zone (2) de base est à dopage du type n.
